Europäisches Patentamt

European Patent Office

Office européen des brevets

(11) Numéro de publication: **0 021 910**

**A1**

## (12) DEMANDE DE BREVET EUROPEEN

(21) Numéro de dépôt: **80400788.8**

(22) Date de dépôt: **03.06.80**

(51) Int. Cl.³: **H 01 L 27/14**

(30) Priorité: **27.06.79 FR 7916560**

(43) Date de publication de la demande:
**07.01.81  Bulletin  81/1**

(84) Etats Contractants Désignés:
**DE GB NL**

(71) Demandeur: **"THOMSON-CSF"**
**173, Boulevard Haussmann**
**F-75360 Paris Cedex 08(FR)**

(72) Inventeur: **Felix, Pierre**
**"THOMSON-CSF" SCPI 173, Bld Haussmann**
**F-75360 Paris Cedex 08(FR)**

(72) Inventeur: **Le Parquier, Guy**
**"THOMSON-CSF" SCPI 173, Bld Haussmann**
**F-75360 Paris Cedex 08(FR)**

(74) Mandataire: **Benichou, Robert et al,**
**"THOMSON-CSF" - SCPI 173 bld Haussmann**
**F-75360 Paris Cedex 08(FR)**

(54) **Mosaique de détecteurs de rayonnement lue par un dispositif semiconducteur, et système de prise de vues comportant une telle mosaique.**

(57) Mosaïque de détecteurs de rayonnement lue par un dispositif semi-conducteur dans laquelle un premier réseau d'électrodes métalliques (E) prélève par couplage capacitif les signaux électriques fournis par les détecteurs (d) à la surface d'une première couche isolante de forte capacité (1) qui sépare ce réseau d'électrodes des détecteurs. Ce premier réseau d'électrodes (E) est électriquement relié à un second réseau d'électrodes (e) dont les dimensions sont inférieures. Les deux réseaux sont séparés par une seconde couche isolante (2) et le second réseau est situé à l'interface de la seconde couche isolante (2) et de la couche d'oxyde (5) qui recouvre le substrat semi-conducteur de lecture (4).

FIG_1

EP 0 021 910 A1

# MOSAIQUE DE DETECTEURS DE RAYONNEMENT LUE PAR UN DISPOSITIF SEMI-CONDUCTEUR, ET SYSTEME DE PRISE DE VUES COMPORTANT UNE TELLE MOSAIQUE.

La présente invention concerne une mosaïque de détecteurs de rayonnement lue par un dispositif semi-conducteur. Elle concerne également un système de prise de vue comportant une telle mosaïque.

Les mosaïques de détecteurs de rayonnement électromagnétique sont connues dans l'art antérieur. Ces mosaïques comportent généralement un réseau de détecteurs constitués d'un matériau pyroélectrique ou de jonctions réalisées sur un substrat semi-conducteur. On connait également des mosaïques uniquement constituées d'une lame de matériau pyroélectrique.

Le réseau de détecteurs est exposé à un rayonnement infra-rouge par exemple, et un signal électrique de lecture est prélevé sur chaque détecteur. Ce signal de lecture peut être prélevé par un faisceau d'électrons ou par un dispositif semi-conducteur, ce qui permet de diminuer avantageusement l'encombrement du système de prise de vues comportant la mosaïque.

L'invention concerne les mosaïques de détecteurs lues par un dispositif semi-conducteur.

Le problème qui se pose alors est celui du couplage électrique et du couplage mécanique entre les parties détection et lecture, c'est-à-dire entre la mosaïque de détecteurs et le dispositif semi-conducteur de lecture.

Il faut, d'une part, prélever dans la partie lecture un signal électrique correspondant à celui qui est généré dans la partie détection par le rayonne-

2

ment électromagnétique avec un rapport signal sur bruit aussi élevé que possible : c'est le problème du couplage électrique.

Il faut, d'autre part, assembler mécaniquement les parties détection et lecture en réduisant les fuites thermiques entre les deux parties, tout en permettant la dilatation thermique des substrats de détection et de lecture qui sont souvent différents : c'est le problème du couplage mécanique.

La présente invention permet de résoudre simplement et efficacement les problèmes de couplage électrique et mécanique des parties détection et lecture.

Selon l'invention, une première couche isolante de forte capacité par unité de surface sépare la surface de la mosaïque sur laquelle sont réalisés les détecteurs, de la couche d'oxyde qui recouvre le substrat semi-conducteur du dispositif de lecture. Enfin, un premier réseau d'électrodes métalliques prélève par couplage capacitif les signaux électriques fournis par les détecteurs à la surface de la première couche isolante, du côté du dispositif de lecture.

D'autre objets, caractéristiques et résultats de l'invention, ressortiront de la description suivante, donnée à titre d'exemple non limitatif et illustrée par les figures annexées qui représentent :

- la figure 1, une vue en coupe transversale d'un mode de réalisation d'une mosaïque selon l'invention ;

- la figure 2, une vue de dessus illustrant un détail de la figure 1 ;

- la figure 3, un schéma électrique équivalent à chaque point élémentaire de la mosaïque de la figure 1 ;

- les figures 4a et 4b, un mode de réalisation d'une mosaïque selon l'invention et un schéma expliquant son fonctionnement ;

- les figures 5a à c, des diagrammes de signaux susceptibles d'être appliqués à la mosaïque de la figure 4a ;

- les figures 6a, 6b et 7, un mode de lecture en courant de la mosaïque représentée sur la figure 4a ;

- la figure 8, un mode de lecture en tension de la mosaïque représentée sur la figure 4a ;

- les figures 9 et 10, deux autres modes de réalisation d'une mosaïque selon l'invention.

Sur les différentes figures, les mêmes repères désignent les mêmes éléments, mais, pour des raisons de clarté, les cotes et proportions des différents éléments n'ont pas été respectées.

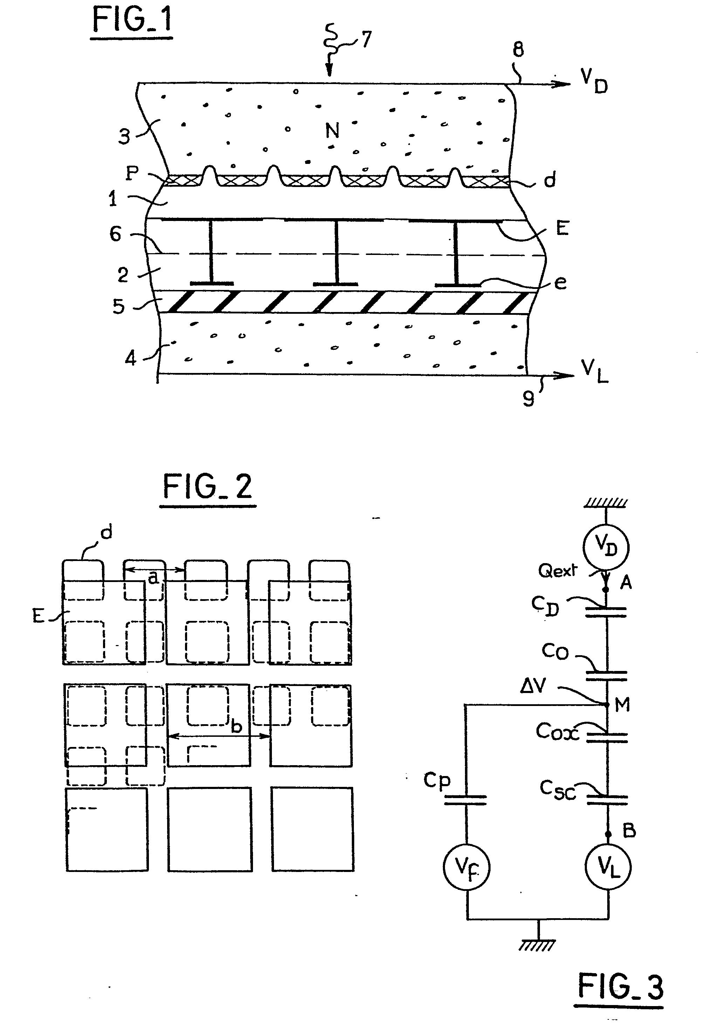

La figure 1 représente une vue en coupe transversale d'un mode de réalisation d'une mosaïque selon l'invention.

Sur la figure 1, à titre d'exemple, les détecteurs d sont des jonctions P-N de structure mésa réalisées sur un substrat semi-conducteur 3. Les détecteurs peuvent être également constitués par des diodes Schottky et leur structure peut être mésa ou planar. La mosaïque peut être également constituée, de façon connue, par une couche continue de matériau semiconducteur dans laquelle les détecteurs sont induits sous forme de puits de pontentiels et qui comporte une

4

couche isolante et des électrodes de prélèvement du signal qui ont une géométrie et une composition particulières.

La mosaïque de détecteurs reçoit un rayonnement électromagnétique qui provient généralement, comme représenté sur la figure par une flèche ondulée 7, du côté du substrat de la mosaïque opposé à celui qui porte les détecteurs. Pour que le rayonnement électromagnétique soit absorbé presque entièrement à proximité des détecteurs, on donne au substrat de la mosaïque une faible épaisseur ou alors on choisit un substrat faiblement dopé et de largeur de bande interdite bien déterminée.

Ainsi, par exemple, dans le cas de la détection d'un rayonnement infra-rouge, le substrat de la mosaïque de détecteurs peut être constitué par un semi-conducteur à faible largeur de bande interdite tel que du sulfure de plomb PbS, du séléniure de plomb PbSe ou du tellurure de plomb PbTe. On peut également utiliser des composés ternaires tels que du tellurure de plomb et d'étain PbSnTe ou du tellurure de mercure et de cadmium HgCdTe. Pour diminuer l'absorption du rayonnement par le substrat de la mosaïque, on peut utiliser un substrat en deux parties qui comporte une première partie en semi-conducteur à faible largeur de bande interdite sur laquelle sont réalisées les jonctions, et une deuxième partie recouvrant la première en semi-conducteur à largeur de bande interdite plus élevée. Dans ce cas, on ne recueille que les photons d'énergie comprise entre les deux largeurs de bande interdite. Ainsi, toujours dans le cas de la détection d'un rayonnement

5

infra-rouge, les détecteurs peuvent être réalisés dans du tellurure de plomb et d'étain PbSnTe recouvert par une couche de tellurure de plomb PbTe.

On a vu précédemment que les détecteurs pouvaient être constitués d'un matériau pyroélectrique et que la mosaïque de détecteurs pouvait être uniquement constituée d'une lame de matériau pyroélectrique. On utilise généralement comme matériau pyroélectrique du tantalate de lithium LiTaO$_3$ ou du sulfate de triglycine ou TGS et ses dérivés.

Le dispositif semi-conducteur de lecture est réalisé sur un substrat semi-conducteur 4 qui est distinct du substrat de la mosaïque de détecteurs. Ce substrat semi-conducteur 4 est recouvert d'une couche d'oxyde 5. On utilise généralement pour la lecture du silicium recouvert d'une couche de silice.

La mosaïque selon l'invention peut également fonctionner lorsque le rayonnement électromagnétique parvient aux détecteurs à travers le dispositif semi-conducteur de lecture.

Selon l'invention, une première couche isolante 1 de forte capacité par unité de surface sépare la surface de la mosaïque sur laquelle sont réalisés les détecteurs d de la couche d'oxyde du substrat semi-conducteur.

Il est également intéressant que cette première couche isolante assure une très faible conductance thermique entre les parties détection et lecture et permettre une adaptation des coefficients de dilatation des substrats de détection et de lecture qui sont souvent différents. Ceci est réalisé lorsque cette première couche isolante est une couche de vide de 1 micron d'épaisseur par exemple. Pour assurer l'adaptation des coefficients de dilatation des substrats, on peut également utiliser un diélectrique plastique tel qu'un film polymère.

Un premier réseau d'électrodes métalliques E prélève par couplage capacitif les signaux électriques fournis par les détecteurs d à la surface de la première couche isolante 1, du côté du dispositif de lecture.

Dans le mode de réalisation de l'invention représenté sur la figure 1, on trouve un second réseau d'électrodes métalliques e qui est séparé du premier par une seconde couche isolante 2 et qui est situé à l'interface de la seconde couche isolante et de la couche d'oxyde 5. Chaque électrode du second réseau est connectée électriquement à une électrode du premier réseau qui lui fait face et dont les dimensions sont supérieures. Ces deux réseaux d'électrodes reliés entre eux permettent de réduire la surface des électrodes e dans le dispositif de lecture qui doit comporter de nombreux éléments, tout en conservant une surface importante aux électrodes de prélèvement du signal E.

La seconde couche isolante 2 peut être constituée du même matériau que la première 1.

Dans le mode de réalisation représenté sur la figure 1, un écran métallique 6, porté à un potentiel $V_f$ fixe est inséré dans la seconde couche isolante 2. Il permet d'isoler électriquement la partie détection des signaux parasites émis par la partie lecture.

7

Des connexions 8 et 9 sont généralement reliées au substrat de détection 3 et au substrat de lecture 4. Ces connexions servent généralement à appliquer à ces substrats des tensions de polarisation $V_D$ et $V_L$.

La figure 2 représente une vue de dessus illustrant un détail de la figure 1. Sur la figure 2, on a représenté la position et les dimensions respectives du premier réseau d'électrodes E et du réseau de détecteurs d. Les électrodes métalliques du premier réseau E peuvent être déposées par évaporation directement sur la première ou sur la deuxième couche isolante. Leur pas élémentaire b, qui correspond à la résolution spatiale dans le système de prise de vues qui comporte la mosaïque, est supérieur au pas élémentaire a des détecteurs d. Cette configuration ne nécessite aucune indexation des détecteurs d par rapport au premier réseau d'électrodes E qui assure le prélèvement du signal sur les détecteurs. Le fonctionnement de la mosaïque selon l'invention ne sera donc pas perturbé par le déplacement du réseau de détecteurs ou du premier réseau d'électrodes, sous l'effet d'une dilatation différentielle par exemple.

La figure 3 représente un schéma électrique équivalent à chaque point élémentaire de la mosaïque représentée sur la figure 1, c'est-à-dire à la surface d'une électrode E du premier réseau.

Ce schéma électrique équivalent comporte quatre capacités en série entre un point A et un point B. On trouve successivement :

- une capacité $C_D$ qui représente la capacité des détecteurs relative à un point élémentaire de résolution ;

8

- une capacité $C_0$ qui représente la capacité relative à la même surface de la première couche isolante 1 de forte capacité ;

- la capacité $C_{OX}$, qui représente la capacité de la couche d'oxyde 5 qui recouvre le substrat semi-conducteur 4 du dispositif de lecture et qui est relative à la surface d'une électrode e du second réseau ;

- la capacité $C_{SC}$, qui représente la capacité de déplétion dans le semi-conducteur 4 du dispositif de lecture et qui est toujours relative à la surface d'une électrode e du second réseau.

Entre le point A et la masse est généralement reliée une source de tension continue qui fournit la tension $V_D$. Entre le point B et la masse est généralement reliée une source de tension continue qui fournit la tension $V_L$.

Entre le point M qui est le point commun aux capacités $C_0$ et $C_{OX}$, et la masse, on a représenté la capacité parasite $C_p$ qui est due à l'écran fixe et la source de tension continue $V_f$ qui polarise cet écran.

Nous allons maintenant examiner le fonctionnement de la mosaïque selon l'invention dans le cas où les détecteurs sont constitués par des jonctions, puis, dans le cas où les détecteurs sont en matériau pyroélectrique (ou lorsque la mosaïque est constituée d'une lamelle en matériau pyroélectrique).

Dans le cas où les détecteurs sont constitués par des jonctions, le dispositif semi-conducteur de lecture assure pour chaque jonction, successivement :

- au cours d'une première étape, sa polarisation en inverse au cours de laquelle se produit l'intégra-

9

gration du rayonnement reçu par la jonction pendant le temps d'intégration $t_i$ ;

– puis, au cours d'une deuxième étape, sa polarisation en direct au cours de laquelle les charges générées optiquement et stockées pendant le temps d'intégration $t_i$ dans la jonction sont réinjectées dans le substrat de détection 3.

Dans le cas d'une détection par matériau pyroélectrique, le dispositif semi-conducteur de lecture assure successivement :

– au cours d'une première étape, l'intégration du rayonnement reçu par le matériau pyroélectrique dont le potentiel est laissé flottant, pendant le temps d'intégration $t_i$ ;

– puis, au cours d'une deuxième étape, la stabilisation à un potentiel de référence du potentiel laissé précédemment flottant.

Si on appelle $Q_D$ la quantité de charges générée optiquement par les détecteurs correspondant à un point élémentaire pendant le temps d'intégration $t_i$, la variation de potentiel, induite sur chaque électrode E du premier réseau, et donc au point M de la figure 3, s'écrit :

$$V = \frac{QD}{CD} \cdot \frac{1/C}{1/C_o + 1/C_D + 1/C} \quad \text{avec}$$

$$C = C_p + 1/(1/C_{OX} + 1/C_{SC}).$$

Dans la pratique, $C_D$ varie de 30 à 1000 nF/cm2 dans le cas de détecteurs à jonctions et de 0,1 à 10 nF/cm2 dans le cas de détecteurs pyroélectriques, $C_o$ est typiquement de 1nF/cm2, ce qui correspond à environ 1 micron de vide, $C_{OX}$ est de l'ordre de 30 nF/cm2, ce qui correspond à 1200 Å de silice

et $C_{SC}$ est de l'ordre de 5 nF/cm2.

Pour les valeurs de $C_D$ supérieures à 30 nF/cm2, approximativement : $\Delta V = \dfrac{C_0^D}{C} \cdot \dfrac{C_D}{C_D} \underset{\sim}{\sim} 0,2 . \dfrac{Q_D}{C_D}$

On constate donc qu'on a intérêt lorsqu'on effectue une lecture en tension en mesurant $\Delta V$ à ce que la capacité $C_0$ soit la plus élevée possible et donc à ce que la première couche isolante 1 ait une très forte capacité par unité de surface.

Lors de la deuxième étape, la quantité de charges $Q_D$ est réinjectée dans le substrat de détection 3, la quantité de charges qui circule alors dans le circuit extérieur, c'est-à-dire entre les points A et B et la masse, s'écrit :

$$Q_{ext} = Q_D \cdot \frac{1/C_D}{1/C_0 + 1/C_D + 1/C} \underset{\sim}{\sim} Q_D \cdot \frac{C_0}{C_D} \cdot$$

La quantité de charges $Q_{ext}$ est donc beaucoup plus faible que la photo-charge $Q_D$. D'où l'intérêt également, lorsqu'on effectue une lecture en courant en mesurant $Q_{est}$, d'une capacité $C_0$ très élevée.

Nous avons vu précédemment que le fonctionnement des mosaïques selon l'invention se faisait en deux étapes. Si nous prenons l'exemple des détecteurs à jonctions, au cours de la première étape, les jonctions sont polarisées en inverse et au cours de la deuxième étape, les jonctions sont polarisées en direct.

Le passage de la première à la deuxieme étape et vice-versa des différents points élémentaires de détection peut se faire soit séquentiellement, soit en parallèle c'est-à-dire en même temps pour tous les points de détection.

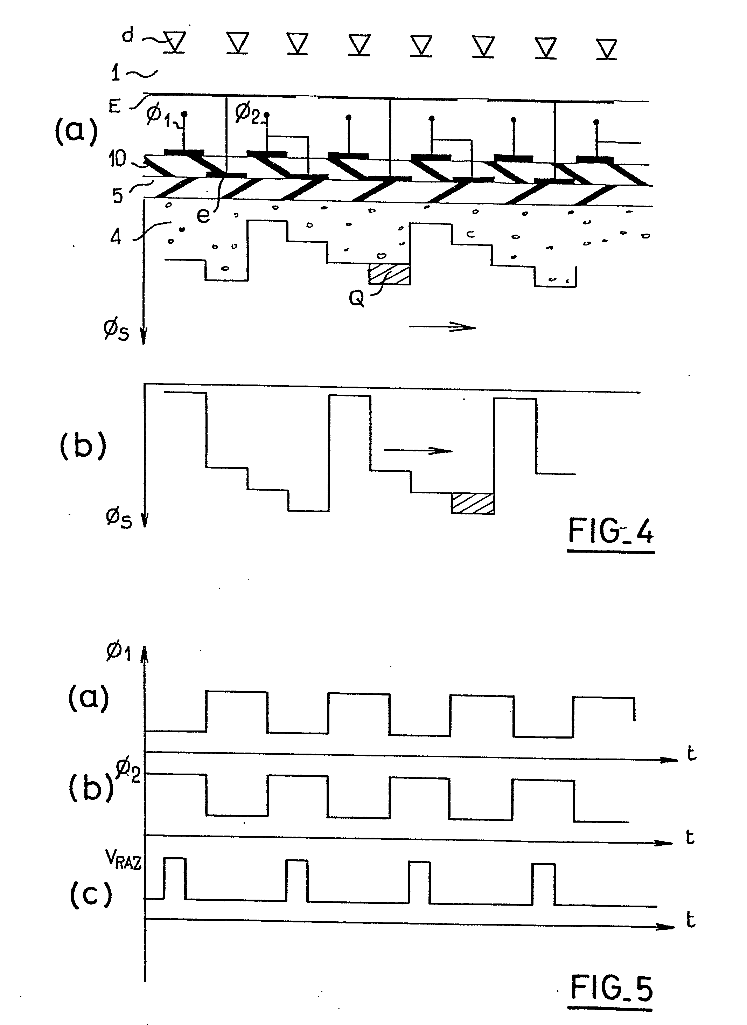

Les figures 4a et 4b représentent un mode de réalisation d'une mosaïque selon l'invention et un schéma expliquant son fonctionnement.

Dans le cas de la figure 4a, le passage de la première à la deuxième étape et vice-versa se fait séquentiellement par déplacement d'une quantité de charges à l'interface entre le substrat de lecture 4 et la couche d'oxyde 5 qui le recouvre, dans un registre CCD intégré dans le substrat de lecture et la couche d'oxyde qui recouvre ce substrat.

Sur la figure 4a, on a représenté par une coupe transversale l'adressage d'une seule ligne de la mosaïque. Pour alléger les figures, la partie détection est symbolisée par des photo-diodes d.

Un registre CCD est donc intégré dans le substrat de lecture 4 et dans la couche d'oxyde 5 qui recouvre ce substrat.

Le registre CCD peut être du type transfert en surface ou transfert en volume. Il peut comporter deux phases ou plus. De même, la création des barrières de potentiels peut être réalisée par implantation d'ions ou par des différences de niveau d'oxyde.

Dans l'exemple représenté sur la figure 4a, le registre CCD comporte deux phases $\phi_1$ et $\phi_2$ et les barrières de potentiel sont réalisées par différences de niveau d'oxyde.

Le registre CCD représenté sur la figure 4a comporte de façon connue deux sortes d'électrodes qui reposent soit sur la couche d'oxyde 5, soit sur une couche supplémentaire d'oxyde 10. Les électrodes e du second réseau constituent une électrode sur deux des électrodes qui reposent sur la couche d'oxyde 5. Parmi les électrodes qui reposent sur la couche supplémentaire 10, une électrode sur deux est reliée à un potentiel $\emptyset_1$ et les autres électrodes sont reliées à un potentiel $\emptyset_2$. Sont également reliées au potentiel $\emptyset_2$, les électrodes qui reposent sur la couche d'oxyde 5 et qui ne sont pas des électrodes e du second réseau. Ces électrodes suivent, selon le sens de transfert des charges indiqué par une flèche, les électrodes situées sur la couche 10 qui sont reliées à $\emptyset_2$. Les potentiels $\emptyset_1$ et $\emptyset_2$ qui sont représentés sur les figures 5a et 5b sont des signaux d'horloge de même période T et sensiblement en opposition de phase avec un léger recouvrement au niveau haut comme cela est d'usage dans le domaine des CCD.

Les électrodes e sont périodiquement reliées, de façon non représentée sur la figure, à un potentiel constant qui établit sous ces électrodes un potentiel de surface intermédiaire entre ceux correspondant au niveau bas et au niveau haut de l'électrode du registre suivante.

Une quantité de charges Q est introduite à l'entrée du registre CCD avec une période de l'ordre du temps d'intégration $t_i$ et bien supérieure à T, suivant l'une des techniques bien connues d'introduction de charges dans un CCD, par exemple la technique d'équilibration de potentiels. Cette quantité de charges est ensuite transférée dans le CCD de proche en proche de façon connue. Sur les figures 4a et 4b, on a représententé le potentiel de surface dans le

substrat 4, $\emptyset_S$, lorsque le potentiel $\emptyset_1$ est au niveau haut, puis lorsque le potentiel $\emptyset_1$ est au niveau bas.

Les substrats de détection et de lecture étant portés en permanence à des potentiels constants $V_D$ et $V_L$, lorsque la quantité de charges Q arrive sous une électrode du second groupe e correspondant à un point élémentaire de détection, elle produit par couplage capacitif la réinjection dans le substrat de détection 3, où elles se recombinent, des charges qui étaient stockées à l'interface des détecteurs et de la couche isolante 1 à forte capacité. La charge Q, quand elle arrive, polarise donc les détecteurs en direct.

Au contraire, quand elle repart d'une électrode e, la charge Q polarise les détecteurs en inverse.

On remarque que ce mode de passage de la première à la deuxième étape et vice-versa, par registre CCD intégré, ne peut être utilisé que dans le cas de détecteurs à jonctions P-N, Schottky ou à jonctions induites. Dans le cas de détecteurs pyroélectriques qui utilisent des matériaux isolants dans lesquels n'existent que des charges liées et aucune charge libre, ce mode de passage d'une étape à l'autre n'est pas applicable.

Nous allons maintenant envisager, à titre d'exemple, divers modes de lecture de la mosaïque représentée sur la figure 4a.

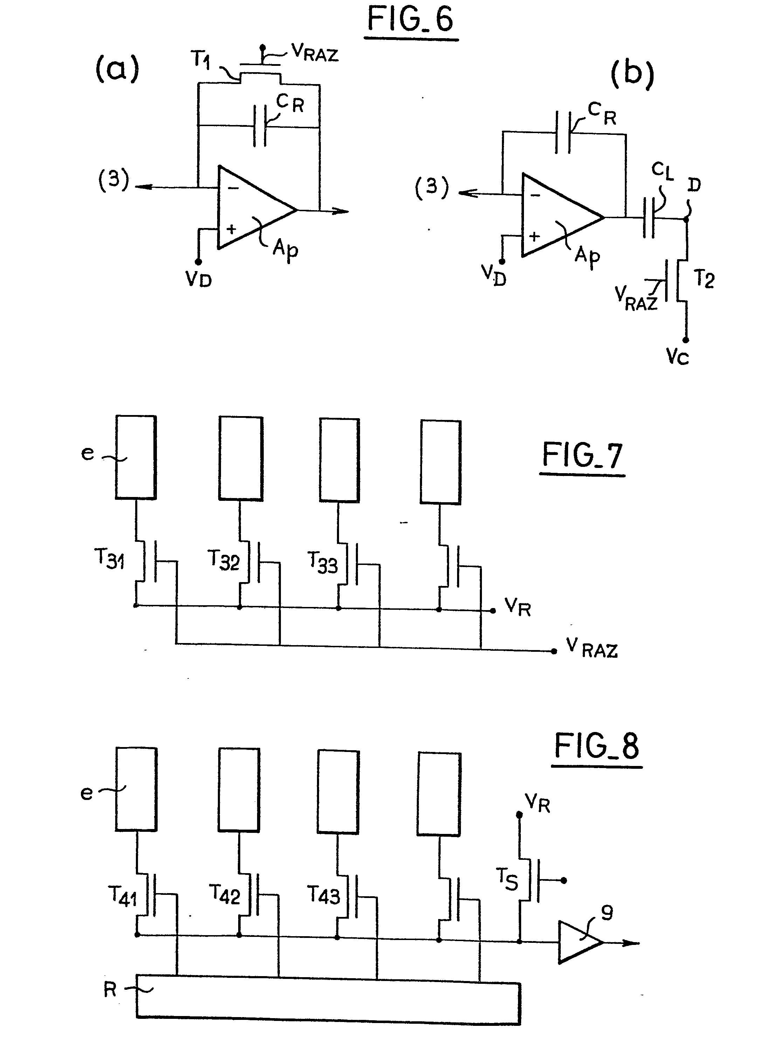

Les figures 6a, 6b et 7 représentent un mode de lecture en courant de cette mosaïque.

Ce mode de lecture consiste, comme cela a déjà été vu lors de la description de la figure 3, à intégrer le courant qui circule dans le circuit d'alimentation du substrat de détection ou du substrat de lecture, c'est-à-dire par exemple entre le point A et la masse, entre la fin de la première étape et le début de la première étape suivante, et donc dans le cas de la figure 4a entre l'instant précédant l'arrivée de la charge d'adressage sous une électrode e et l'instant suivant son départ.

Pour cela, on utilise sur les figures 6a et 6b, un amplificateur opérationnel $A_p$ monté en intégrateur avec une capacité $C_R$. L'entrée positive de cet amplificateur est reliée à la tension du substrat de détection $V_D$. Son entrée négative est reliée au substrat de détection 3.

Sur la figure 6a, la capacité $C_R$ est court-circuitée après chaque lecture du courant par un transistor MOS $T_1$ qui est monté en parallèle sur cette capacité. Ce transistor $T_1$ reçoit sur sa grille un signal périodique $V_{RAZ}$ qui est représenté sur la figure 5c de signal $V_{RAZ}$ a une période égale à T et se trouve au niveau haut alors que $\emptyset_1$ est au niveau bas. L'inconvénient du mode de réalisation représenté sur la figure 6a est que le transistor $T_1$ constitue une source de bruit qui peut perturber la lecture du courant.

Dans le mode de réalisation représenté sur la figure 6b, cette source de bruit est supprimée. Dans ce mode de réalisation, un transistor $T_2$ commandé par $V_{RAZ}$ se trouve monté entre un point D et une tension constante $V_C$, ce point D étant séparé de la sortie de l'amplificateur opérationnel par une capacité de liaison $C_L$. Ainsi, après chaque lecture du courant, la sortie du dispositif de lecture est

15

portée à un niveau continu de référence.

Dans le cas des figures 6a et 6b, la sortie du dispositif de lecture peut être suivie d'un circuit d'échantillonnage et maintien classique qui permet d'avoir en sortie un signal vidéo continu.

La figure 7 représente un perfectionnement qui peut être apporté au mode de lecture en courant illustré par les figures 6a et 6b. Chaque électrode du second réseau e peut être portée périodiquement à un potentiel de référence $V_R$ par des transistors MOS $T_{31}$, $T_{32}$, $T_{33}$... qui sont reliés d'une part à une électrode e et d'autre part à la tension $V_R$ et qui reçoivent un signal périodique de période T. Ce signal périodique rend les transistors $T_{31}$, $T_{32}$, $T_{33}$ conducteurs lorsque la phase $\emptyset_2$ se trouve au niveau haut, c'est-à-dire pendant la première étape où se produit l'intégration des photocharges dans les détecteurs. Le signal $V_{RAZ}$ peut être utilisé à cet effet. Le potentiel des électrodes e étant sensiblement constant pendant le temps d'intégration $t_i$, on peut ainsi stocker davantage de charges pour une même polarisation initiale des détecteurs tout en évitant la saturation ; le temps d'intégration $t_i$ peut ainsi être augmenté.

Les transistors MOS utilisés dans le dispositif de lecture peuvent être intégrés dans le substrat semi-conducteur de lecture 4 qui est déjà utilisé pour le registre CCD.

La figure 8 illustre un mode de lecture en tension de la mosaïque représentée sur la figure 4a.

16

Un registre d'adressage à sorties multiples R a chacune de ses sorties reliée à la grille d'un transistor MOS $T_{41}$, $T_{42}$, $T_{43}$ ... Chacun de ces transistors MOS est connecté entre une électrode du second réseau e et un pré-amplificateur de sortie 9. Le registre d'adressage R et les transistors $T_{41}$, $T_{42}$, $T_{43}$.. peuvent être intégrés dans le substrat de lecture 4. Lrsque le registre d'adressage adresse l'une de ses sorties, on obtient à l'entrée du pré-amplificateur 9 la tension sur l'électrode e à laquelle cette entrée est reliée par l'intermédiaire d'un transistor MOS.

On peut mesurer la différence des tensions sur chaque électrode e entre le début de la première étape et la fin de la première étape, c'est-à-dire pendant le temps d'intégration $t_i$. Dans ce cas, le registre d'adressage à sorties multiples R rend conducteur le transistor MOS qui est relié à l'électrode e à lire entre l'instant qui suit le départ de la quantité de charges d'adressage et l'instant qui précède le passage de la quantité de charges d'adressage suivante. Un circuit d'échantillonnage et de maintien est généralement relié au pré-amplificateur 9. Le temps d'intégration $t_i$ peut être ajusté en faisant varier l'instant d'adressage par le registre R de l'électrode e lue.

On peut également mesurer la différence des tensions sur chaque électrode e entre la fin de la première étape et le début de la première étape suivante. Dans ce cas également, le registre d'adressage à sorties multiples R doit rendre conducteur le transistor MOS connecté à l'électrode e a lire entre l'instant qui précède le passage de la quantité de charges d'adressage et l'instant oui suit le départ de cette quantité de charges. Dans ce cas, le temps de lecture de la tension est très inférieur au temps d'intégration $t_i$, ce qui permet de réduire avantageusement l'influence des bruits, fluctuations ou dérives à basse fréquence.

Un transistor MOS $T_S$ relié entre l'entrée du préamplificateur 9 et la tension de référence $V_R$ permet de porter chaque électrode e à la tension de référence $V_R$ immédiatement après sa lecture.

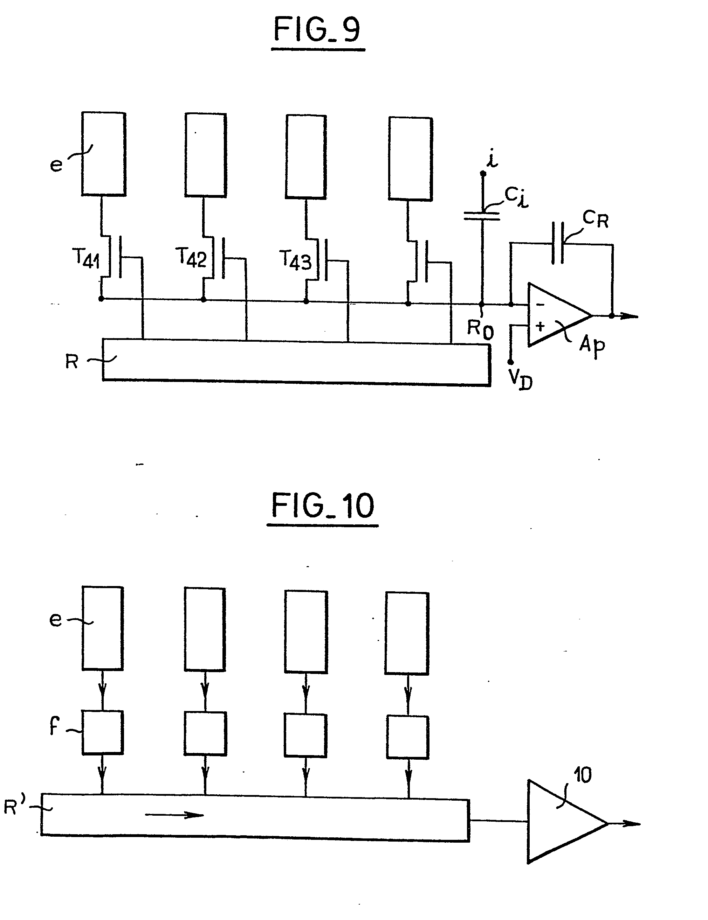

La figure 9 représente un autre mode de réalisation d'une mosaïque selon l'invention.

Le passage de la première à la deuxième étape et vice-versa se fait séquentiellement, non plus par un registre CCD, mais simplement par un registre d'adressage à sorties multiples R qui comporte plusieurs sorties. Chaque sortie est connectée à la grille d'un transistor MOS $T_{41}$, $T_{42}$, $T_{43}$ ..., qui est reliée entre l'une des électrodes e du second réseau et un point commun $R_o$ qui reçoit périodiquement, par l'intermédiaire d'une capacité $C_i$, une impulsion i provoquant le passage d'une étape à l'autre des détecteurs qui la reçoivent.

Le substrat de détection 3 et le substrat de lecture 4 sont portés en permanence à des potentiels constants $V_D$ et $V_L$.

La lecture des électrodes e peut se faire en courant en utilisant, comme dans le cas des figures 6a et 6b, un amplificateur opérationnel $A_p$ monté en intégrateur avec une capacité $C_R$.

La lecture en courant peut se faire, comme dans le cas des figures 6a et 6b, en intégrant le courant qui circule dans le circuit de polarisation du substrat de détection entre la fin de la première étape et le début de la première étape suivante. On peut aussi intégrer l'évolution du courant dans le circuit de polarisation relié aux électrodes, c'est-à-dire à la sortie de l'amplificateur $A_p$.

On peut également réaliser une lecture en tension de la façon exposée dans la description de la figure 8. Le dispositif de lecture ainsi réalisé est plus simple que celui qui est obtenu dans le cas où le passage d'un état à l'autre se fait par un registre CCD, mais il ne permet pas d'obtenir un temps d'intégration $t_i$ ajustable comme c'était le cas avec le registre CCD.

Le passage de la première à la deuxième étape et vice-versa peut également se faire en parallèle, c'est-à-dir en même temps pour tous les détecteurs. Ceci peut être obtenu en agissant sur la polarisation des substrats de détection et de lecture ou en agissant sur la polarisation des électrodes e du second réseau qui sont reliées en parallèle. Dans le cas des détecteurs pyroélectriques, on ne peut utiliser que la polarisation variable des électrodes e du second réseau. La figure 10 représente un autre mode de réalisation d'une mosaïque selon l'invention dans laquelle le passage d'une étape à l'autre se fait en parallèle. On utilise alors un registre CCD R' qui assure un transfert latéral, selon le sens indiqué par une flèche sur la figure, des quantités de charges correspondant à la lecture effectuée au même instant sur les électrodes e. Ce registre CCD réalise donc une lecture multiplexée des détecteurs d'une ligne de la mosaïque. Un pré-ampli-

19

ficateur 10 est relié à ce registre. Le registre R' et le pré-amplificateur 10 peuvent être intégrés dans le substrat de lecture. Entre chaque électrode e du second réseau et une entrée du registre CCD, se trouve intercalé un dispositif f qui assure la conversion de la tension sur chaque électrode e en charges qui peuvent être introduites dans le CCD. En effet, pendant le temp d'intégration $t_i$ les électrodes e sont flottantes, c'est-à-dire qu'elles ne sont reliées à aucune tension de polarisation, leur potentiel évolue donc et c'est cette mesure de l'évolution de la tension sur les électrodes e pendant le temps d'intégration qui constitue le signal de lecture de la mosaïque. La conversion de la tension sur les électrodes e en charges dans le registre CCD peut être réalisée de diverses façons connues et notamment par la méthode d'équilibration de potentiels qui est décrite dans la revue IEEE, Journal of Solid State Circuits, volume SC 10, N°. 2, avril 1975.

20

## REVENDICATIONS

1. Mosaïque de détecteurs de rayonnement lus par un dispositif semi-conducteur, comportant un réseau de détecteurs exposés au rayonnement et fournissant un signal électrique, ce réseau étant réalisé sur un substrat distinct du substrat semi-conducteur recouvert d'une couche d'oxyde qui sert à la lecture, caractérisée en ce qu'une première couche isolante (1) de forte capacité par unité de surface sépare la surface de la mosaïque sur laquelle sont réalisés les détecteurs (d) de la couche d'oxyde (5) qui recouvre le substrat semi-conducteur (4), et caractérisée en ce qu'un premier réseau d'électrodes métalliques (E) prélève par couplage capacitif les signaux électriques fournis par les détecteurs à la surface de la première couche isolante, du côté du dispositif de lecture.

2. Mosaïque selon la revendication 1, caractérisée en ce qu'elle comporte un second réseau d'électrodes métalliques (e), séparé du premier par une seconde couche isolante (2) et situé à l'interface de la seconde couche isolante et de la couche d'oxyde (5), chaque électrode du second réseau étant connectée électriquement à une électrode du premier réseau qui lui fait face et dont les dimensions sont supérieures.

3. Mosaïque selon l'une des revendications 1 ou 2, caractérisée en ce qu'un écran métallique (6) porté à un potentiel fixe ($V_f$) est inséré dans la seconde couche isolante (2).

4. Mosaïque selon l'une des revendications 1, 2 ou 3, caractérisée en ce que les détecteurs (d) sont des jonctions P-N ou Schottky, de structure mésa ou planar, réalisées sur un substrat semi-conducteur (3).

5. Mosaïque selon l'une des revendications 1, 2 ou 3, caractérisée en ce que les détecteurs (d) sont en matériau pyroélectrique.

6. Mosaïque selon l'une des revendications 1, 2 ou 3, caractérisée en ce qu'elle est constituée par une lamelle de matériau pyroélectrique.

7. Mosaïque selon l'une des revendications 1 à 6, caractérisée en ce que la première couche isolante (1) est une couche de vide.

8. Mosaïque selon l'une des revendications 1 à 6, caractérisée en ce que la première couche isolante (1) est un diélectrique plastique.

9. Mosaïque selon la revendication 4, caractérisée en ce que le dispositif semi-conducteur de lecture assure pour chaque jonction, successivement :

- au cours d'une première étape, sa polarisation en inverse, au cours de laquelle se produit l'intégration du rayonnement reçu par la jonction ;

- puis, au cours d'une deuxième étape, sa polarisation en direct.

10. Mosaïque selon l'une des revendications 5 ou 6, caractérisée en ce que le dispositif semi-conducteur de lecture assure successivement.

- au cours d'une première étape, l'intégration du rayonnement reçu par chaque détecteur en matériau pyroélectrique ou par la lamelle en matériau pyroélectrique, dont le potentiel est laissé flottant ;

- au cours d'une deuxième étape, la stabilisation à un potentiel de référence du potentiel laissé

22

précédemment flottant.

11. Mosaïque selon l'une des revendications 9 ou 10, caractérisée en ce que le dispositif de lecture assure une lecture en courant en intégrant le courant qui circule dans le circuit de polarisation du substrat de détection (3) ou du substrat de lecture (4), portés en permanence à un potentiel constant ($V_D$), entre la fin de la première étape et le début de la première étape suivante.

12. Mosaïque selon l'une des revendications 9 ou 10, caractérisée en ce que le dispositif de lecture assure une lecture en tension en mesurant la différence des tensions sur chaque électrode pendant le temps d'intégration ($t_i$), entre le début de la première étape et la fin de la première étape.

13. Mosaïque selon la revendication 9, caractérisée en ce que le dispositif de lecture assure une lecture en tension en mesurant la différence des tensions sur chaque électrode, entre la fin de la première étape et le début de la première étape suivante.

14. Mosaïque selon la revendication 9, caractérisée en ce que le passage de la première à la deuxième étape et vice-versa se fait séquentiellement, par déplacement d'une quantité de charges à l'interface entre le substrat de lecture (4) et la couche d'oxyde (5) qui le recouvre, dans un registre CCD intégré dans le dispositif de lecture.

15. Mosaïque selon l'une des revendications 9 ou 10, caractérisée en ce que le passage de la première à la deuxième étape et vice-versa se fait séquentiellement grâce à un registre d'adressage (R) comportant

23

plusieurs sorties adressables séparément, chaque sortie étant connectée à la grille d'un transistor MOS relié entre l'une des électrodes du second réseau (e) et un point commun ($R_o$) qui reçoit périodiquement une impulsion (i) provoquant le passage d'une étape à l'autre des électrodes qui la reçoivent.

16. Mosaïque selon la revendication 12, caractérisée en ce qu'un dispositif CCD intégré dans le substrat semi-conducteur de lecture (4) assure la transformation en charges de la tension représentant la lecture.

17. Système de prise de vues, caractérisé en ce qu'il comporte une mosaïque selon l'une des revendications 1 à 16.

## FIG_1

## FIG_2

## FIG_3

FIG_4

FIG_5

FIG_6

(a)

$T_1$ — $V_{RAZ}$

$C_R$

(3) ←

$A_p$

$V_D$

(b)

$C_R$

$C_L$ D

(3) ←

$A_p$

$V_D$

$V_{RAZ}$ $T_2$

$V_C$

FIG_7

e

$T_{31}$   $T_{32}$   $T_{33}$

$V_R$

$V_{RAZ}$

FIG_8

e

$V_R$

$T_{41}$   $T_{42}$   $T_{43}$   $T_S$

9

R

## FIG_9

## FIG_10

0021910

Numéro de la demande

**Office européen des brevets**

**RAPPORT DE RECHERCHE EUROPEENNE**

EP 80 40 0788

| Catégorie | Citation du document avec indication, en cas de besoin, des parties pertinentes | Revendication concernée | CLASSEMENT DE LA DEMANDE (Int. Cl. 3) |
|---|---|---|---|
| | DOCUMENTS CONSIDERES COMME PERTINENTS | | |
| | US - A - 3 973 146 (NORTH AMERICAN PHILIPS CORP.)<br><br>* Colonne 1, ligne 58 - colonne 3, ligne 28; colonne 3, ligne 45 - colonne 4, ligne 28; figures 1-4 * | 1,5,6, 17 | H 01 L 27/14 |
| | -- | | |
| | PROCEEDING OF THE IEEE, vol. 63, no. 1, janvier 1975 New York US A.J. STECKL et al.: "Application of charge-coupled devices to infrared detection and imaging" pages 67-74.<br><br>* En entier * | 1,5 | DOMAINES TECHNIQUES RECHERCHES (Int. Cl. 3)<br><br>H 01 L 27/14<br>27/16 |
| | -- | | |
| | GB - A - 1 258 572 (PLESSEY)<br>* Pages 2,3; figures * | 1,4,9, 11 | |
| | -- | | |
| P | US - A - 4 197 469 (ROCKWELL INT. CORP.)<br><br>* En entier * | 1,2, 17 | |
| | ---- | | CATEGORIE DES DOCUMENTS CITES |

CATEGORIE DES DOCUMENTS CITES

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 22-09-1980 | ROUBERT |

OEB Form 1503.1   06.78